# EUROPÄISCHE PATENTSCHRIFT

(11) **EP 4 300 542 B1**
(45) Veröffentlichungstag und Bekanntmachung des Hinweises auf die Patenterteilung: **07.05.2025**
(21) Anmeldenummer: 23210279.8
(22) Anmeldetag: 12.12.2019
(51) Int. Cl.: B28D 5/00, B28D 5/04, B23D 59/00, H01L 21/02

(54) **VERFAHREN ZUR HERSTELLUNG VON HALBLEITERSCHEIBEN MITTELS EINER DRAHTSÄGE, DRAHTSÄGE UND HALBLEITERSCHEIBE AUS EINKRISTALLINEM SILIZIUM**
METHOD FOR PRODUCING SEMICONDUCTOR WAFERS USING A WIRE SAW, WIRE SAW, AND SEMICONDUCTOR WAFER MADE OF MONOCRYSTALLINE SILICON
PROCÉDÉ DE FABRICATION DE TRANCHES DE SEMI-CONDUCTEUR AU MOYEN D'UNE SCIE À FIL, SCIE À FIL ET TRANCHE DE SEMI-CONDUCTEUR EN SILICIUM MONOCRISTALLIN

(30) Priorität: 17.12.2018 DE 102018221922
(43) Veröffentlichungstag der Anmeldung: 03.01.2024
(62) Teilanmeldung aus: 19828238.6
(73) Patentinhaber: Siltronic AG, 81677 München (DE)
(72) Erfinder: Beyer, Axel, Seoul (Granciel 3cha, Bangbae-dong) (KR); Welsch, Stefan, 84570 Polling (DE)
(74) Vertreter: Grundner, Sebastian

(56) Entgegenhaltungen:
- DE-T5- 112016 005 417
- US-A1- 2008 166 948
- US-A1- 2015 004 799

## Beschreibung

Die Erfindung bezieht sich auf ein Verfahren zur Herstellung von Halbleiterscheiben aus einem Werkstück durch Bearbeiten des Werkstücks mittels einer Drahtsäge, eine Drahtsäge zur Durchführung des Verfahrens und eine Halbleiterscheibe aus einkristallinem Silizium, die durch das Verfahren zugänglich wird. Insbesondere betrifft die Erfindung eine Halbleiterscheibe, gemäß dem Oberbegriff des Patentanspruchs 1. Eine derartige Halbleiterscheibe geht aus der DE 11 2016 005417 T5 hervor.

### Stand der Technik / Probleme

In WO 2015/188 859 A1 sind eine Drahtsäge und deren Funktionsprinzip ausführlich dargestellt.

Aus JP 09 109 143 A ist ein Verfahren zur Herstellung von Scheiben (wafers) aus einem Werkstück (ingot) mittels einer Drahtsäge bekannt, das folgende Schritte umfasst: das Detektieren der Position von Drähten eines Drahtfelds der Drahtsäge und beim Vorliegen einer Auslenkung der Drähte das Herbeiführen einer Ausgleichsbewegung einer Drahtführungsrolle zur Korrektur der Auslenkung.

Aus JP 11 165 251 ist ein ähnliches Verfahren bekannt, das folgende Schritte umfasst: das Detektieren der Position von Drähten eines Drahtfelds der Drahtsäge und beim Vorliegen einer Auslenkung der Drähte das Herbeiführen einer Ausgleichsbewegung des Werkstücks.

Aus US 5 875 770 ist ein ähnliches Verfahren bekannt, das folgende Schritte umfasst: das Detektieren des warp von Scheiben vor der Bearbeitung des Werkstücks und das Herbeiführen einer Ausgleichsbewegung des Werkstücks entlang einer axialen Richtung des Werkstücks in einem Umfang, dass Scheiben mit reduziertem warp entstehen.

Aus JP 2009 61 527 A ist ein ähnliches Verfahren bekannt, das dem Umstand, dass sich das Werkstück auf Grund von Wärmeausdehnung axial bewegen kann, Rechnung trägt, indem Mittel vorgesehen sind, den Drahtführungsrollen eine kompensierende Bewegung zu ermöglichen.

Ungeachtet dieser zur Verfügung stehenden Lösungen besteht weiterhin Bedarf an einer Verbesserung des Verfahrens zur Herstellung von Halbleiterscheiben aus einem Werkstück mittels einer Drahtsäge. Insbesondere ist zu berücksichtigen, dass die axiale Bewegung des Werkstücks auf Grund von Wärmeausdehnung nur näherungsweise durch eine entsprechende axiale Bewegung der Drahtführungsrollen ausgeglichen werden kann. Darüber hinaus ist eine Regelung der axialen Positionen der Drähte über die Temperatur der Drahtführungsrollen vergleichsweise träge. Ferner kann der gemessene warp von Scheiben aus einem vorher bearbeiteten Werkstück nur näherungsweise Abweichungen für ein noch zu bearbeitendes Werkstück beschreiben und die axiale Bewegung eines gesamten Werkstücks solche Abweichungen nur teilweise kompensieren.

Notwendig ist insbesondere eine Verbesserung des Verfahrens, damit Halbleiterscheiben zugänglich werden, deren Ebenheit insbesondere hinsichtlich warp und Nanotopographie besser ist, als diejenige von Scheiben, die in bekannter Weise hergestellt werden.

Aus der beschriebenen Problematik ergab sich die Aufgabenstellung der Erfindung. Die Patentschrift offenbart ein Verfahren zur Herstellung von Halbleiterscheiben aus einem Werkstück durch Bearbeiten des Werkstücks mittels einer Drahtsäge, umfassend
das Zustellen des Werkstücks durch eine Anordnung von Drähten, die in Drahtgruppen gegliedert zwischen Drahtführungsrollen gespannt sind und sich in eine Laufrichtung bewegen;
das Erzeugen von Schnittspalten beim Eingriff der Drähte in das Werkstück;
für jede der Drahtgruppen das Ermitteln einer Fehllage der Schnittspalte der Drahtgruppe; und
für jede der Drahtgruppen das Herbeiführen von Ausgleichsbewegungen der Drähte der Drahtgruppe in Abhängigkeit der ermittelten Fehllage der Schnittspalte der Drahtgruppe in eine Richtung senkrecht zur Laufrichtung der Drähte der Drahtgruppe während des Zustellens des Werkstücks durch die Anordnung von Drähten durch Aktivieren mindestens eines Antriebselements.

Es sind mindestens zwei Drahtgruppen vorgesehen, vorzugsweise mindestens drei Drahtgruppen und besonders bevorzugt vier Drahtgruppen, aber es ist auch möglich, dass jeder Draht als eigene Drahtgruppe aufgefasst wird, also die Anzahl der Drahtgruppen der Anzahl der Drähte der Anordnung von Drähten (Drahtgatter) entspricht. Drahtgruppen haben vorzugsweise dieselbe axiale Breite und der Abstand zwischen benachbarten Drähten einer Drahtgruppe ist derselbe.

Für jede der Drahtgruppen gesondert, werden Ausgleichsbewegungen der Drähte der Drahtgruppe in eine Richtung senkrecht zur Laufrichtung der Drähte der Drahtgruppe, also in Richtung der Drehachsen der Drahtführungsrollen, herbeigeführt. Zu diesem Zweck wird mindestens ein Antriebselement aktiviert, das die Drähte in die vorgesehene Richtung und über die vorgesehene Strecke verschiebt. Die Ausgleichsbewegungen der Drähte der Drahtgruppe werden unabhängig von einem gegebenenfalls gleichzeitig erfolgenden Herbeiführen von Ausgleichsbewegungen der Drähte einer anderen Drahtgruppe herbeigeführt.

Als Antriebselement kommen insbesondere elektromagnetische, mechanische, hydraulische, pneumatische, magnetostriktive und vorzugsweise piezoelektrische Aktoren in Betracht. Sind die Drähte beispielsweise in vier Drahtgruppen gegliedert, bilden die Drahtgruppen zwei innere und zwei äußere Drahtgruppen. Dehnt sich das Werkstück auf Grund von Wärme aus, ist die Fehllage eines Schnittspalts, der einem Draht einer der inneren Drahtgruppen zuzuordnen ist geringer als diejenige, die einem Draht einer der äußeren Drahtgruppen zuzuordnen ist. Dementsprechend müssen die Beträge der Ausgleichsbewegungen der Drähte der äußeren Drahtgruppen größer gewählt werden, als der Betrag der Ausgleichsbewegungen der Drähte der inneren Drahtgruppen. Im Fall, dass jeder Draht als eigene Drahtgruppe aufgefasst wird, wird jeder Draht einer Ausgleichsbewegung mit eigenem Betrag und eigener Richtung unterworfen.

Eine vom Werkstück abgetrennte Halbleiterscheibe hat eine obere und eine untere Seitenfläche und eine zwischen beiden verlaufende Kante. Üblicherweise wird angestrebt, dass die obere und untere Seitenfläche nach dem Abtrennen vom Werkstück möglichst eben sind und einen möglichst gleichmäßigen Abstand zueinander haben. Je besser die Ebenheit der Seitenflächen und die Gleichmäßigkeit der Dicke der Halbleiterscheibe anfänglich sind, desto eher gelingt es und desto geringer wird der Aufwand, die Halbleiterscheibe durch nachfolgende Schritte wie Läppen und/oder Schleifen, Ätzen, Polieren und gegebenenfalls Beschichten in ein Zielprodukt zu veredeln, das den strengen Anforderungen der Industrie genügt, die die Halbleiterscheibe zu elektronischen Bauelementen weiterverarbeitet. Die obere Seitenfläche wird auch als Vorderseite der Halbleiterscheibe bezeichnet und ist in der Regel diejenige Fläche, auf der oder in die im Zuge einer Weiterverarbeitung der Halbleiterscheibe beabsichtigt ist, Strukturen elektronischer Bauelemente unterzubringen.

Das Verfahren verfolgt das Ziel, beim Bearbeiten des Werkstücks mittels einer Drahtsäge dafür zu sorgen, dass Schnittspalte im Werkstück entstehen, deren Lage möglichst geringfügig von einer als ideal angesehenen Lage abweicht. Werden Halbleiterscheiben mit einheitlicher Dicke und möglichst ebenen Seitenflächen angestrebt, verläuft ein idealer Schnittspalt geradlinig und rechtwinkelig zur Längsachse des Werkstücks. Mit anderen Worten ausgedrückt, die Trajektorie durch die Mitte eines solchen Schnittspalts läuft entlang einer Geraden, die senkrecht zur Längsachse des Werkstücks orientiert ist. Eine solche Trajektorie wird nachfolgend als angestrebte Trajektorie bezeichnet. Demnach liegt eine Fehllage eines Schnittspalts vor, wenn die tatsächliche Trajektorie von der angestrebten Trajektorie abweicht. Das ist dann der Fall, wenn ein Ortsvektor, der zur Mitte des Schnittspalts zeigt, nicht mehr auf der angestrebten Trajektorie endet.

Eine Fehllage eines Schnittspalts entsteht beispielsweise, wenn sich ein Draht während des Eingriffs in das Werkstück senkrecht zu seiner Laufrichtung, also in Richtung der Drehachsen der Drahtführungsrollen bewegt, zwischen denen er gespannt ist, oder wenn sich das Werkstück während des Zustellens durch die Anordnung von Drähten auf Grund von Wärmeentwicklung axial ausdehnt. Die Fehllage eines Schnittspalts ist im zuletzt genannten Fall umso größer, je mehr Abstand der Schnittspalt zur Mitte des Werkstücks hat. Die Mitte des Werkstücks ist der Ort zwischen den beiden Enden des Werkstücks.

Ein Aspekt des Verfahrens ist, für jede Drahtgruppe gesondert, die Fehllage der Schnittspalte zu ermitteln, unabhängig davon, welche Ursache zu einer Relativbewegung zwischen Werkstück und Drahtgruppe geführt hat. Beispiele für solche Ursachen sind eine Bewegung der Drahtgruppe, eine Bewegung des Werkstücks oder eine thermische Ausdehnung des Werkstücks. Ein weiterer Aspekt des Verfahrens ist, zu unterscheiden zwischen einer Fehllage der Schnittspalte, die systematisch bei Verwendung einer bestimmten Drahtsäge auftritt, und einer Fehllage der Schnittspalte, die zufällig und unabhängig von der Verwendung einer bestimmten Drahtsäge auftritt.

Zweckmäßigerweise wird, für jede der Drahtgruppen gesondert, mindestens ein geschlossener Regelkreis eingerichtet, in dem auf eine Regelabweichung, also auf eine ermittelte Fehllage der Schnittspalte der Drahtgruppe, mit einer Veränderung der Stellgröße, also dem Herbeiführen einer Ausgleichsbewegung der Drähte der Drahtgruppe reagiert wird.

Gemäß einer ersten Ausgestaltung des Verfahrens erfolgt das Ermitteln der Fehllage der Schnittspalte der Drahtgruppe, für jede Drahtgruppe gesondert, während des Zustellens des Werkstücks durch die Anordnung von Drähten. Gemäß einer ersten Alternative der ersten Ausgestaltung wird die Position vorzugsweise eines jeden Schnittspalts relativ zu einem feststehenden Bezugspunkt gemessen und mit einer Soll-Position verglichen. Die Soll-Position eines Schnittspalts ist die Position relativ zum feststehenden Bezugspunkt, die Voraussetzung wäre, damit ein idealer Schnittspalt entstehen kann. Die Abweichung der gemessenen Position des Schnittspalts von dessen Soll-Position entspricht der Fehllage des Schnittspalts. Da die Abweichung für jeden Schnittspalt der Drahtgruppe grundsätzlich unterschiedlich sind, werden die Abweichungen zu einer Fehllage gemittelt, die die Fehllage der Schnittspalte der Drahtgruppe repräsentiert. Mit anderen Worten, jedem Schnittspalt der Drahtgruppe wird die gleiche, gemittelte Fehllage zugeordnet. Die Mittelung kann ohne Gewichtung erfolgen oder Fehllagen bestimmter Schnittspalte werden besonders gewichtet. Aus der Fehllage der Schnittspalte der Drahtgruppe lässt sich ein Korrekturprofil ableiten, das vorgibt, mit welchem Betrag und in welche Richtung die Drähte der Drahtgruppe während des Zustellens des Werkstücks bewegt werden müssen, um die Fehllage der Schnittspalte zu beseitigen. Das Korrekturprofil hat, betrachtet über die Eindringtiefe der Drähte in das Werkstück, einen Verlauf, der komplementär zum Verlauf der ermittelten Fehllage der Schnittspalte der Drahtgruppe ist.

Das Messen der Position der Schnittspalte der Drahtgruppe erfolgt vorzugsweise mittels Bestrahlung der Schnittspalte der Drahtgruppe mit optischer Strahlung, IR-Strahlung, Röntgen-Strahlung oder γ-Strahlung. Darüber hinaus kommt auch eine mechanische Abtastung der Schnittspalte der Drahtgruppe oder eine induktive oder kapazitive Messung der Schnittspalte der Drahtgruppe in Betracht. Eine solche direkte Beobachtung der Schnittspalte der Drahtgruppe legt jede Relativbewegung zwischen dem Werkstück und den Drähten einer Drahtgruppe offen.

Gemäß einer zweiten Alternative der ersten Ausgestaltung wird die Position vorzugsweise eines jeden Drahts einer Drahtgruppe und des Werkstücks relativ zu einem feststehenden Bezugspunkt zeitgleich gemessen und mit einer Soll-Position verglichen, um eine solche Relativbewegung zu erfassen. Da die Abweichung für jeden Draht der Drahtgruppe grundsätzlich unterschiedlich ist, werden die Abweichungen zu einer Fehllage gemittelt, die die Fehllage der Drähte der Drahtgruppe repräsentiert. Mit anderen Worten, jedem Draht der Drahtgruppe wird die gleiche, gemittelte Fehllage zugeordnet. Die Mittelung kann ohne Gewichtung erfolgen oder Fehllagen bestimmter Schnittspalte werden besonders gewichtet. Die Soll-Position des Drahts ist die Position des Drahts relativ zum feststehenden Bezugspunkt, die Voraussetzung wäre, damit ein idealer Schnittspalt entstehen kann. Entsprechendes gilt für die Soll-Position des Werkstücks. Aus der Summe der gemessenen Abweichungen von den Soll-Positionen von Draht und Werkstück wird die Abweichung der tatsächlichen Trajektorie von der angestrebten Trajektorie näherungsweise bestimmt.

Das Messen der Position der Drähte der Drahtgruppe beziehungsweise der Position des Werkstücks erfolgt mittels Bestrahlung der Drähte der Drahtgruppe beziehungsweise des Werkstücks mit optischer Strahlung, IR-Strahlung, Röntgen-Strahlung oder γ-Strahlung, oder mittels kapazitiver oder induktiver Messung. Darüber hinaus kommt auch eine mechanische Abtastung der Drähte der Drahtgruppe beziehungsweise des Werkstücks oder eine induktive oder kapazitive Messung der Drähte der Drahtgruppe beziehungsweise des Werkstücks in Betracht. Die Position des Werkstücks kann relativ zu Stirnflächen des Werkstücks und vorzugsweise relativ zu auf dem Werkstück markierten Referenzpunkten ermittelt werden.

Gemäß einer zweiten Ausgestaltung des Verfahrens erfolgt das Ermitteln der Fehllage der Schnittspalte der Drahtgruppe, für jede Drahtgruppe gesondert, vor dem Zustellen des Werkstücks durch die Anordnung von Drähten. Aufgrund dieser Vorgehensweise wird eine Fehllage der Schnittspalte ermittelt, die systematisch bei Verwendung einer bestimmten Drahtsäge auftritt. Zum Ermitteln der Fehllage der Schnittspalte wird die lokale Geometrie von Halbleiterscheiben, die zuvor mittels einer bestimmten Drahtsäge hergestellt wurden, gemessen. Diese Halbleiterscheiben stammen von einem oder mehreren Werkstücken, die mittels dieser Drahtsäge hergestellt wurden und zwar mittels Drähten der Drahtgruppe, für die die Fehllage der Schnittspalte ermittelt wird. Die lokale Geometrie einer Halbleiterscheibe bildet näherungsweise die Trajektorie des der Halbleiterscheibe benachbarten Schnittspalts ab. Vorzugsweise wird die lokale Geometrie von der Medianfläche einer warp-Messung nach SEMI MF 1390-0218 abgeleitet und zwar wie folgt: eine Höhenlinie (line scan, LS) wird erzeugt durch Selektion derjenigen Messwerte der Medianfläche, welche sich auf einer Linie befinden, die durch das Zentrum der Halbleiterscheibe verläuft. Die Messwerte liegen auf einer Linie, die einem Durchmesser der Halbleiterscheibe vorzugsweise in Richtung des Zustellens des Werkstücks beim Abtrennen der Halbleiterscheibe folgt oder zumindest um nicht mehr als ± 20° von einer solchen Richtung abweicht.

Um eine Fehllage der Schnittspalte der Drahtgruppe zu erkennen, die systematisch beim Verwenden einer bestimmten Drahtsäge auftritt, wird die lokale Geometrie der Halbleiterscheiben, die von einem oder mehreren Werkstücken, die mittels dieser Drahtsäge hergestellt wurden, stammen und mittels Drähten der Drahtgruppe erzeugt wurden, zu einer einzigen lokalen Geometrie gemittelt. Die Mittelung kann ohne Gewichtung erfolgen oder die lokale Geometrie bestimmter Halbleiterscheiben wird auf Grund von deren relativen Lage im Werkstück besonders gewichtet. Ausgehend von der gemittelten lokalen Geometrie wird dann geschlossen, wie die Trajektorie des Schnittspalts sein wird, falls die bestimmte Drahtsäge verwendet wird und weitere Einflüsse, die sich auf die Trajektorie auswirken, außer Betracht bleiben. Eine solche Trajektorie wird nachfolgend die zu erwartende Trajektorie genannt. Die Fehllage der Schnittspalte der Drahtgruppe, mit der während des Zustellens des Werkstücks zu rechnen ist, ergibt sich aus dem Vergleich der zu erwartenden Trajektorie mit der anzustrebenden Trajektorie. Der Vergleich liefert ein drahtsägespezifisches Korrekturprofil, das Richtung und Betrag der Ausgleichsbewegungen der Drähte der Drahtgruppe in Abhängigkeit der Eindringtiefe der Drähte in das Werkstück während des Zustellens des Werkstücks durch die Anordnung von Drähten vorgibt. Der Verlauf des drahtsägespezifischen Korrekturprofils ist im Prinzip komplementär zum Verlauf der gemittelten lokalen Geometrie.

Das drahtsägespezifische Korrekturprofil wird vorzugsweise zusätzlich herangezogen, um frühzeitig Veränderungen des Leistungsverhaltens der Drahtsäge erkennen und darauf reagieren zu können. Veränderungen des drahtsägespezifischen Korrekturprofils, die im Verlauf der Bearbeitung von Werkstücken auftreten, weisen auf einen Verschleiß des Drahts und/oder des Belags der Drahtführungsrollen oder eines anderen, einem Verschleiß unterworfenen Bauteils der Drahtsäge hin. Es kann deshalb eine Schwelle für die Veränderung des drahtsägespezifischen Korrekturprofils definiert werden, bei deren Erreichen vorsorgliche Wartungsmaßnahmen (predictive maintenance) eingeleitet werden. Auch vor dem Erreichen einer solcher Schwelle können Veränderungen des drahtsägespezifischen Korrekturprofils zum Anlass genommen werden, um Anpassungsmaßnahmen vorzunehmen, die einer verschleißbedingten Verschlechterung des Arbeitsergebnisses entgegenwirken. Solche Anpassungsmaßnahmen können beispielsweise die Änderung der Zusammensetzung und/oder der Temperatur einer Schneidmittel-Suspension oder die Änderung der Temperatur eines Kühlmittels beinhalten, ebenso wie die Änderung der Drahtgeschwindigkeit oder anderer prozessspezifischer Parameter.

Eine dritte Ausgestaltung des Verfahrens sieht vor, die erste und die zweite Ausgestaltung zu kombinieren. Ein erster Teil der Ausgleichsbewegungen der Drähte der Drahtgruppe wird auf der Grundlage eines Korrekturprofils herbeigeführt, das entsprechend der ersten Ausgestaltung des Verfahrens in Echtzeit während des Zustellens des Werkstücks in Abhängigkeit der Eindringtiefe der Drähte der Drahtgruppe ermittelt wird. Ein weiterer Teil der Ausgleichsbewegungen der Drähte der Drahtgruppe wird auf der Grundlage eines drahtsägespezifischen Korrekturprofils herbeigeführt, das entsprechend der zweiten Ausgestaltung des Verfahrens vor dem Zustellen des Werkstücks durch die Anordnung von Drähten für die jeweilige Drahtgruppe, ermittelt wurde. Damit werden Einflüsse auf die Fehllage der Schnittspalte, die zufällig auftreten und deshalb nicht vorhersehbar sind und solche, die wegen der Verwendung einer bestimmten Drahtsäge systematisch auftreten, voneinander entkoppelt berücksichtigt.

Ein drahtsägespezifisches Korrekturprofil kann selbstverständlich auch durch Aufzeichnen des Korrekturprofils erhalten werden, das gemäß der ersten Ausgestaltung des Verfahrens abgeleitet wird.

Die offenbarten Verfahren können in Verbindung mit Drähten genutzt werden, die am Draht gebundenes Schneidkorn aufweisen, oder in Verbindung mit Drähten, die frei davon sind und ihre Wirkung in Kombination mit einer Schneidmittel-Suspension entfalten. Als gebundenes Schneidkorn kommt insbesondere Diamant in Frage. Die Drähte, von denen hier die Rede ist, sind Abschnitte eines Drahts, der um die Drahtführungsrollen der Drahtsäge gewickelt ist. Die Anzahl der Drahtführungsrollen der Drahtsäge ist nicht wesentlich für die Nutzung des Verfahrens. Beispielsweise kann die Drahtsäge zwei, drei, vier oder eine noch höhere Anzahl von Drahtführungsrollen umfassen.

Das Werkstück besteht vorzugsweise aus einem Halbleitermaterial wie Silizium, das in multikristallinem oder einkristallinem Zustand vorliegen kann. Der Umfang des Werkstücks ist quadratisch, rechteckig oder kreisförmig. Das Verfahren eignet sich insbesondere zur Herstellung von runden Halbleiterscheiben aus einkristallinem Silizium mit einem Durchmesser von mindestens 200 mm, insbesondere mindestens 300 mm.

Des Weiteren wird eine Drahtsäge zur Herstellung von Halbleiterscheiben durch Bearbeiten eines Werkstücks offenbart, umfassend Drahtführungsrollen, zwischen denen Drähte zu einer Anordnung von Drähten gespannt sind, die in Drahtgruppen gegliedert sind und sich in eine Laufrichtung bewegen;
eine Einheit zum Zustellen des Werkstücks durch die Anordnung von Drähten unter Erzeugen von Schnittspalten beim Eingriff der Drähte in das Werkstück;
Antriebselemente, von denen mindestens eines einer jeden der Drahtgruppen zugeordnet ist, zum Bewegen der Drähte der zugeordneten Drahtgruppe; und
eine Steuerungseinheit zum Aktivieren der Antriebselemente, wobei die Steuerungseinheit beim Vorliegen einer Fehllage der Schnittspalte der Drahtgruppen dasjenige Antriebselement aktiviert, welches der Drahtgruppe zugeordnet ist, wodurch die Drähte dieser Drahtgruppe Ausgleichsbewegungen senkrecht zur Laufrichtung ausführen.

Die Drahtsäge umfasst eine Einheit zum Zustellen eines Werkstücks durch eine Anordnung von Drähten, die zwischen Drahtführungsrollen gespannt sind.

Die Drahtsäge kann zwei oder mehrere Drahtführungsrollen umfassen, um die Sägedraht gewickelt ist. Bei der Drahtsäge sind die Drähte in Drahtgruppen gegliedert, und mindestens ein Antriebselement ist jeder der Drahtgruppen zugeordnet. Beim Aktivieren eines Antriebselements werden die Drähte der ihm zugeordneten Drahtgruppe senkrecht zur Laufrichtung der Drähte bewegt, also in Richtung der Drehachsen der Drahtführungsrollen. Das aktivierte Antriebselement bewegt die Drähte der ihm zugeordneten Drahtgruppe gleichzeitig mit demselben Betrag in die dieselbe Richtung. Wegen der Zuordnung der Antriebselemente sind der Betrag und die Richtung der Bewegung der Drähte einer Drahtgruppe unabhängig vom Betrag und der Richtung der Bewegung der Drähte einer anderen Drahtgruppe. Die Drahtführungsrollen, zwischen denen die zu Drahtgruppen gegliederten Drähte gespannt sind, so dass sie die Anordnung von Drähten bilden, sind mit den Antriebselementen versehen. Die Antriebselemente sind zwischen den Drahtgruppen mindestens einer der Drahtführungsrollen angeordnet, zwischen denen das Werkstück durch die Anordnung von Drähten zugestellt wird. Es ist nicht nötig, aber auch nicht ausgeschlossen, dass auch die andere, das Drahtgatter aufspannende Drahtführungsrolle ebenfalls mit solchen Antriebselementen versehen sind.

Die Drahtsäge umfasst des Weiteren eine Steuerungseinheit zum Aktivieren der Antriebselemente. Beim Vorliegen einer Fehllage der Schnittspalte einer Drahtgruppe, aktiviert die Steuerungseinheit das Antriebselement, das der Drahtgruppe zugeordnet ist, woraufhin die Drähte dieser Drahtgruppe eine Ausgleichsbewegung vollziehen, die die ermittelte Fehllage der Schnittspalte reduziert oder aufhebt.

Die Steuerungseinheit greift entweder auf Daten zur Fehllage der Schnittspalte zu, die während des Zustellens des Werkstücks mittels einer Messvorrichtung entsprechend der ersten Ausgestaltung des Verfahrens bereitgestellt werden, oder auf drahtsägespezifische Daten, die in einem Datenspeicher abgelegt sind und vor dem Zustellen des Werkstücks entsprechend der zweiten Ausgestaltung des Verfahrens zur Verfügung gestellt werden, oder sowohl auf die einen als auch auf die anderen Daten.

Die Messvorrichtung dient, getrennt für jede Drahtgruppe, zum Ermitteln der Fehllage der Schnittspalte der jeweiligen Drahtgruppe während des Zustellens des Werkstücks durch die Anordnung von Drähten. Die Information zur Fehllage der Schnittspalte der Drahtgruppe wird der Steuerungseinheit übermittelt und dort zu einem Signal (Stellgröße) für die Aktivierung des Antriebselements, das der entsprechenden Drahtgruppe zugeordnet ist, weiterverarbeitet. Die Messvorrichtung und die Steuerungseinheit sind Komponenten eines ersten geschlossenen Regelkreises zur Minimierung der Fehllagen der Schnittspalte. Mittels dieses Regelkreises wird, für jede Drahtgruppe gesondert, das der Drahtgruppe zugeordnete Antriebselement aktiviert und zwar unabhängig von der gegebenenfalls gleichzeitig herbeigeführten Aktivierung eines Antriebselements, das einer anderen der Drahtgruppen zugeordnet ist.

Der Datenspeicher dient zum Vorhalten von Daten zur Aktivierung der Antriebselemente. Die Daten bilden ein drahtsägespezifisches Korrekturprofil ab, und zwar ein eigenes für jede der Drahtgruppen. Ein solches drahtsägespezifisches Korrekturprofil gibt die Richtung und den Betrag der Ausgleichsbewegungen der Drähte der Drahtgruppe in Abhängigkeit der Eindringtiefe der Drähte in das Werkstück vor. Die Steuerungseinheit greift auf diese Daten während des Zustellens des Werkstücks durch die Anordnung von Drähten zu und aktiviert das der jeweiligen Drahtgruppe zugeordnete Antriebselement entsprechend der Vorgaben des für die Drähte dieser Drahtgruppe geltenden drahtsägespezifischen Korrekturprofils. Vorzugsweise sind der Datenspeicher und die Steuerungseinheit Komponenten eines weiteren geschlossenen Regelkreises zur Minimierung der Fehllagen der Schnittspalte.

Verfügt die Drahtsäge über den Datenspeicher, wird vorzugsweise auch eine Recheneinheit zum Verfolgen von Veränderungen eines drahtsägespezifischen Korrekturprofils im Verlauf der Bearbeitung mehrerer Werkstücke bereitgestellt. Beim Erreichen einer festgelegten Schwelle der Veränderungen gibt die Recheneinheit ein Signal zum Einleiten einer vorsorglichen Wartungsmaßnahme aus.

Die Aufgabe der Erfindung wird gelöst durch eine Halbleiterscheibe, gemäß dem Patentanspruch 1, aus einkristallinem Silizium mit einer oberen Seitenfläche und einer unteren Seitenfläche, umfassend
einen warp von weniger als 1,2 µm;
eine Nanotopographie der oberen Seitenfläche, ausgedrückt als THA25 10%, von weniger als 5 nm; und
eine teilflächenbezogene Nanotopographie der oberen Seitenfläche von weniger als 6 nm, ausgedrückt als maximaler peak-to-valley Abstand auf einer Teilfläche und bezogen auf Teilflächen mit einem Flächeninhalt von jeweils 25 mm x 25 mm.

Die Halbleiterscheibe hat einen Durchmesser von mindestens 200 mm besonders bevorzugt einen Durchmesser von 300 mm. Die oben angegebenen Eigenschaften der Halbleiterscheibe zu warp, Nanotopographie und flächenbezogene Nanotopographie beziehen sich auf eine Halbleiterscheibe mit einem Durchmesser von 300 mm.

Der warp der Halbleiterscheibe wird entsprechend der Norm SEMI MF 1390-0218 bestimmt.

Zur Untersuchung der Nanotopographie wird ein Interferometer, beispielsweise ein Gerät vom Typ WaferSight^{™} der KLA-Tencor Corp. verwendet. Ein solches Interferometer eignet sich zur Messung der Topographie auf der oberen Seitenfläche einer Halbleiterscheibe. Das Gerät bildet eine Höhenkarte der oberen Seitenfläche der Halbleiterscheibe ab, die gefiltert wird und über die ein Analysenfenster mit definierter Analysenfläche bewegt wird. Die Auswertung der Höhenunterschiede im Analysenfenster erfolgt durch THA (threshold height analysis) entsprechend der Normen SEMI M43-0418 und SEMI M78-0618 festgelegten Verfahrensvorschriften. THAXX 10% < 5 nm bedeutet, dass höchstens 10 % der analysierten Fläche der oberen Seitenfläche der Halbleiterscheibe im Analysenfenster mit der durch XX spezifizierten Analysenfläche einen maximalen PV-Abstand (peak-to-valley Metrik) von 5 nm oder größer haben darf. Bei einer erfindungsgemäßen Halbleiterscheibe beträgt die Nanotopographie der oberen Seitenfläche, ausgedrückt als THA25 10%, weniger als 5 nm, wobei ein Analysenfenster mit kreisförmigen Umfang und einem Durchmesser von 25 mm zur Anwendung kommt und das ungefilterte Topographiesignal mit einem einfachen gaußschen Hoch-Pass-Filter (single Gaussian filter) mit 20 mm Grenzwellenlänge gefiltert wird. Die Grenzwellenlänge schrumpft bis zum Rand der Halbeiterscheibe auf 1 mm. Vor dem Filtern wird ein Randausschluss von 5 mm, nach dem Filtern ein Randausschluss von 15 mm beachtet.

Bei der Messung der Nanotopographie der oberen Seitenfläche kann sich die Halbleiterscheibe im Zustand nach dem Abtrennen vom Werkstück befinden oder in einem Zustand im Anschluss dem Abtrennen nachfolgender Bearbeitungsschritte, wie dem Ätzen und dem Polieren. Vorzugsweise liegt die obere Seitenfläche der Halbleiterscheibe in poliertem Zustand vor.

Die Nanotopographie wird teilflächenbezogen ausgewertet, also bezogen auf anwenderspezifische Teilflächen (sites) der oberen Seitenfläche der Halbleiterscheibe. Es wird wie vorstehend beschrieben, der PV-Abstand bestimmt (Analysenfenster mit kreisförmigem Umfang und einem Durchmesser von 25 mm, einfacher gaußscher Hochpass-Filter, Grenzwellenlänge 20 mm zum Rand der Halbleiterscheibe hin auf 1 mm schrumpfend). Der Randausschluss beträgt jedoch vor dem Filtern 2 mm und nach dem Filtern 3 mm. Die obere Seitenfläche der Halbleiterscheibe wird in Teilflächen unterteilt, die sich um eine Teilfläche (site) gruppieren, deren linke untere Ecke im Zentrum der oberen Seitenfläche der Halbleiterscheibe angeordnet ist. Bei einer erfindungsgemäßen Halbleiterscheibe beträgt die teilflächenbezogene Nanotopographie der oberen Seitenfläche weniger als 6 nm, ausgedrückt als maximaler PV-Abstand auf einer Teilfläche und bezogen auf Teilflächen mit einem Flächeninhalt von 25 mm x 25 mm.

Die Erfindung wird nachfolgend unter Bezugnahme auf Zeichnungen weiter erläutert.

### Kurzbeschreibung der Figuren

**Fig. 1** zeigt Hauptmerkmale einer zum Stand der Technik gehörenden Drahtsäge.
**Fig. 2** zeigt Merkmale einer Drahtführungsrolle der Drahtsäge.
**Fig.3** zeigt schematisch den Ablauf des Verfahrens.
**Fig.4** zeigt, wie sich eine tatsächliche Trajektorie durch die Mitte eines Schnittspalts von einer anzustrebenden Trajektorie unterscheiden kann.
**Fig.5** und **Fig.6** zeigen an zwei Beispielen Richtung und Beträge möglicher Ausgleichsbewegungen von Drahtgruppen.
**Fig.7** zeigt ein typisches Korrekturprofil, auf der Grundlage dessen Ausgleichsbewegungen der Drähte einer Drahtgruppe herbeigeführt werden.
**Fig.8** bis **Fig.10** und **Fig.11** bis **Fig.13** zeigen von Medianflächen einer warp-Messung abgeleitete Höhenlinien von jeweils drei Halbleiterscheiben.
**Fig.14** bis **Fig.16** entsprechen **Fig.8** bis **Fig.10** mit dem Unterschied einer höher aufgelösten Skalierung der Ordinate.
Die **Fig.17, 18** und **19** zeigen, wie sich ein drahtsägespezifisches Korrekturprofil im Verlauf der Bearbeitung von mehreren Werkstücken verändern kann.

### Liste der verwendeten Bezugszeichen

- **1**: Sägedraht
- **2**: Rillen
- **3**: linke Drahtführungsrolle
- **4**: rechte Drahtführungsrolle
- **5**: Achse
- **6**: Achse
- **7**: Rotation
- **8**: Drehrichtung
- **9**: Drahtlängsbewegung
- **10**: Drahtlängsbewegung
- **11**: Drahtgatter
- **12**: Zustelleinrichtung
- **13**: Schnittspalt
- **14**: Achse
- **15**: Werkstück
- **16**: Sägeleiste
- **17**: Kleber
- **18**: Pfeilrichtung
- **19**: Düsenkamm
- **20**: Düsenkamm
- **21**: Düsen
- **22**: Strahl
- **23**: Strahl
- **24a-e**: Antriebselement
- **25a-d**: Drahtgruppe
- **26**: Festlager
- **27**: Lager
- **28**: Steuerungseinheit
- **29**: Datenvorgabe
- **30**: Messvorrichtung
- **31**: Datenspeicher
- **32**: anzustrebende Trajektorie

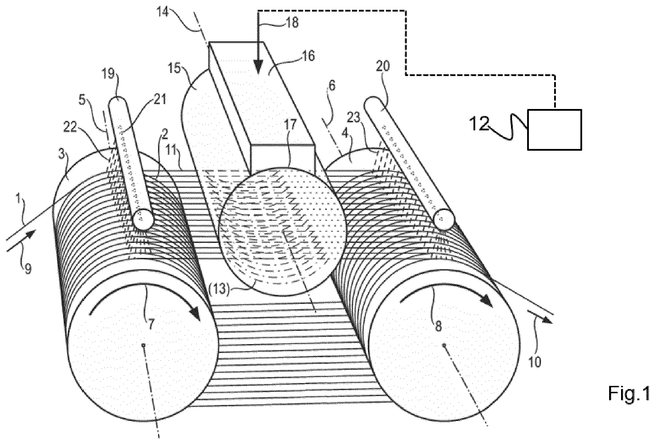

Fig.1 zeigt Hauptmerkmale einer zum Stand der Technik gehörenden Drahtsäge und dient zur Erläuterung von Grundlagen eines Verfahrens zur Herstellung von Halbleiterscheiben aus einem Werkstück durch Bearbeiten des Werkstücks mittels einer Drahtsäge.

Eine geeignete Drahtsäge umfasst Sägedraht 1, der mehrfach spiralförmig um eine linke Drahtführungsrolle 3 und eine rechte Drahtführungsrolle 4 umgelegt und von Rillen 2 so geführt wird, dass die auf der Oberseite der Drahtführungsrollen verlaufenden Drahtabschnitte, die zur Beschreibung des Ausführungsbeispiels als Drähte bezeichnet werden, parallel verlaufen und ein Drahtgatter 11 bilden. Ein Werkstück 15 ist an einer Sägeleiste 16 befestigt, beispielsweise mittels eines Klebers 17 geklebt. Die Sägeleiste 16 wird mit dem Werkstück 15 von einer andeutungsweise dargestellten Zustelleinrichtung 12 in Pfeilrichtung 18 senkrecht gegen das Drahtgatter 11 zugestellt und mit den Drähten des Drahtgatters 11 in Eingriff gebracht. Gegebenenfalls umfasst die Drahtsäge linke Düsenkämme 19 und rechte Düsenkämme 20 mit Düsen 21 zum Zuführen einer Schneidmittel-Suspension in Form eines linken länglichen Strahls 22 und eines rechten länglichen Strahls 23 auf die linke Drahtführungsrolle 3 und die rechte Drahtführungsrolle 4.

Die Drahtführungsrollen sind um Achsen 5 und 6 drehbar gelagert. Ihre Achsen und die Achse 14 des Werkstücks 15 - im gezeigten Beispiel ein zylindrischer Stab - sind parallel zueinander ausgerichtet. Zum Einleiten des Trennvorgangs wird eine Drahtführungsrolle, beispielsweise die linke Drahtführungsrolle 3, zur Rotation 7 angetrieben ("Master"). Die andere Drahtführungsrolle("Slave"), im Beispiel die rechte Drahtführungsrolle 4, dreht sich, durch Draht 1 gezogen, gleichsinnig in Drehrichtung 8 mit. Beim Eingreifen der Drähte in das Werkstück 15 bilden sich Schnittspalte 13.

Üblicherweise wird die Richtung der Drahtlängsbewegung 9, 10 mehrfach während eines vollständigen Schnitts durch das Werkstück 15 umgekehrt, wobei in jedem einzelnen dieser "Pilgerschritt" genannten Paare aus Richtungsumkehrungen der Draht um eine größere Länge in die eine und eine kleinere Länge in die entgegengesetzte Richtung bewegt wird.

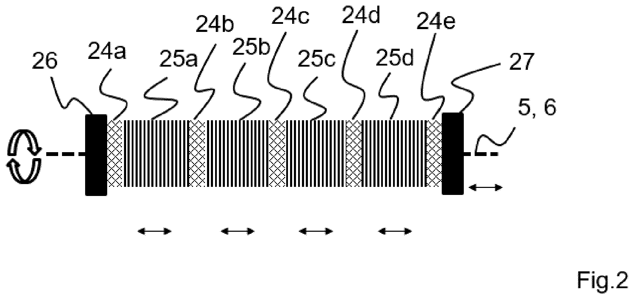

Eine Drahtsäge, gemäß dem Ausführungsbeispiel, weist mindestens eine Drahtführungsrolle auf, die Antriebselemente umfasst. Ein Beispiel einer solchen Drahtführungsrolle ist in Fig.2 dargestellt. Bei Aktivierung eines Antriebselements wird eine aktivierte Drahtgruppe in eine Richtung senkrecht zur Laufrichtung der Drähte der Drahtgruppe bewegt. Im dargestellten Beispiel sind fünf Antriebselemente 24a-e und vier Drahtgruppen 25a-d zwischen dem Festlager 26 und dem Lager 27 der Drahtführungsrolle vorgesehen. Das Lager 27 kann als Loslager oder als Festlager ausgeführt sein. Auf das Antriebselement 24e, das an das Lager 27 angrenzt, kann verzichtet werden, falls das Lager 27 ein Loslager ist. Ungeachtet dessen ist das Lager 27 im dargestellten Beispiel als Loslager gezeichnet. Die Doppelpfeile weisen auf mögliche Bewegungsrichtungen hin, in die sich eine Drahtgruppe bewegt, wenn das ihr zugeordnete Antriebselement aktiviert wird. Die Drahtführungsrolle kann in mit Rillen für Drähte versehene Segmente unterteilt sein, die auf einer Welle angeordnet sind, beispielsweise in Segmente, wie sie in JP 11 123 649 A2 beschrieben sind. Ein Antriebselement ist dann zwischen jedem Ende der Segmente und an Festlager angrenzend positioniert. Bei einem derartigen Aufbau verfügt die in Fig.2 dargestellte Drahtführungsrolle über eine Anzahl von Segmenten, die der Anzahl der Drahtgruppen entspricht.

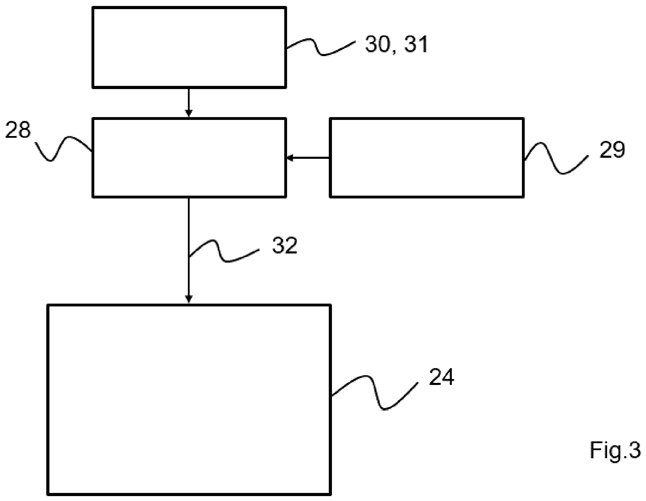

Fig.3 zeigt schematisch den Ablauf, wie eine Steuerungseinheit 28 aufgrund von Daten zu einer Fehllage der Schnittspalte einer Drahtgruppe mit einem Korrektursignal 32 basierend auf einem Korrekturprofil und/oder einem drahtsägespezifischen Korrekturprofil auf Antriebselemente 24 einwirkt, wodurch die Drähte der Drahtgruppen 25 Ausgleichsbewegungen vollziehen. Die Steuerungseinheit 28 erhält den dazu notwendigen Input von einer Messvorrichtung 30 und/oder einem Datenspeicher 31, in dem das drahtsägespezifische Korrekturprofil abgelegt ist.

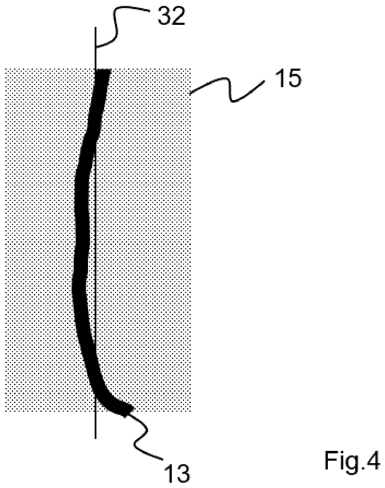

Fig.4 zeigt im Querschnitt ein Bild, das sich entweder durch Beobachten der Schnittspalte oder durch Beobachten der Drähte und des Werkstücks während des Eingriffs der Drähte in das Werkstück gewinnen lässt. Es zeigt einen Teil des Werkstücks 15 und einen Schnittspalt 13, der sich durch das Werkstück erstreckt. Die tatsächliche Trajektorie, die durch die Mitte des Schnittspalts 13 verläuft, weicht während des Entstehens des Schnittspalts mehr oder weniger deutlich von einer anzustrebenden Trajektorie 32 ab. Die Differenz repräsentiert die ermittelte Fehllage des Schnittspalts 13. Wie erwähnt, ist vorgesehen, für jede Drahtgruppe Ausgleichsbewegungen der Drähte der Drahtgruppe in Abhängigkeit der ermittelten Fehllage der Schnittspalte der Drahtgruppe in eine Richtung senkrecht zur Laufrichtung der Drähte der Drahtgruppe herbeizuführen und zwar durch Aktivieren eines Antriebselements, das der jeweiligen Drahtgruppe zugeordnet ist.

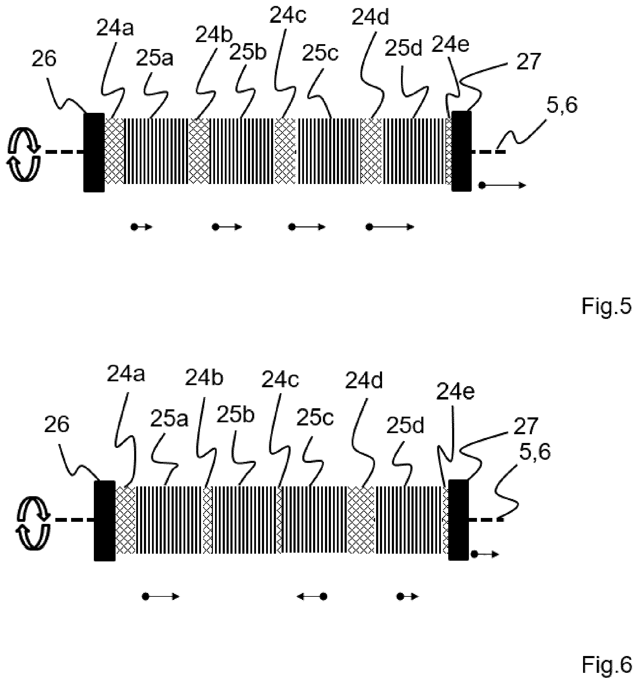

Fig.5 und Fig.6 zeigen an zwei Beispielen Richtung und Beträge möglicher Ausgleichsbewegungen von Drahtgruppen. Die Antriebselemente 24a-e sind beispielsweise piezoelektrische Aktoren. Im Fall von Fig.5 bewirkt die gleichartige Aktivierung der in Fig.2 gezeigten Antriebselemente 24a-d, dass sich die piezoelektrischen Aktoren jeweils um denselben Betrag ausdehnen, so dass die Drahtgruppen 25a-d und das Lager 27 der Drahtführungsrolle dementsprechend vom Festlager 26 wegbewegt werden. Der Betrag der Ausgleichsbewegung steigt, wie es die Pfeile andeuten, von der Drahtgruppe 25a bis zur Drahtgruppe 25d gleichmäßig an. Es kann aber beispielsweise auch erforderlich sein, dass, wie es in Fig.6 dargestellt ist, Ausgleichsbewegungen erforderlich sind, im Zuge derer sich Drahtgruppen gegeneinander bewegen. In Fig.6 ist das Ergebnis zu sehen, wenn die in Fig.2 gezeigten Antriebselemente derart aktiviert werden, dass sich das Antriebselement 24a mit einem Betrag a und das Antriebselement 24d mit einem Betrag d (Betrag d > Betrag a) zum Lager 27 ausdehnen und das Antriebselement 24b mit einem Betrag b und das Antriebselement 24c mit einem Betrag c (Betrag c > Betrag d) zum Festlager 26 schrumpfen. In der Summe ergeben sich dann die mit Pfeilen angedeuteten Ausgleichsbewegungen der Drähte der Drahtgruppen und des Lagers 27: Die Drähte der Drahtgruppe 25a werden mit dem größten Betrag zum Lager 27 bewegt, die Drähte der Drahtgruppe 25b werden nicht bewegt, die Drähte der Drahtgruppe 25c werden mit einem Betrag zum Festlager 26 bewegt und die Drähte der Drahtgruppe 25d mit dem geringsten Betrag zum Lager 27.

Der Vergleich von tatsächlicher Trajektorie und anzustrebender Trajektorie gemäß der ersten Ausgestaltung beziehungsweise der Vergleich von zu erwartender Trajektorie und anzustrebender Trajektorie gemäß der zweiten Ausgestaltung führt zu einer Beschreibung des Verlaufs der Fehllage der Schnittspalte einer Drahtgruppe in Abhängigkeit der Eindringtiefe der Drähte der Drahtgruppe im Werkstück und zu einem Korrekturprofil (erste Ausgestaltung) beziehungsweise zu einem drahtsägespezifischen Korrekturprofil (zweite Ausgestaltung), das komplementär zum Verlauf der Fehllage der Schnittspalte ist.

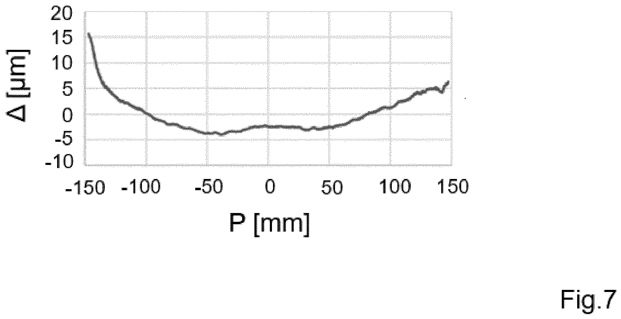

Fig.7 zeigt ein Korrekturprofil, in dem die Abweichung Δ der tatsächlichen Trajektorie von der anzustrebenden Trajektorie in Abhängigkeit der Eindringtiefe P der Drähte der Drahtgruppe aufgetragen ist. Ausgleichsbewegungen der Drähte der Drahtgruppe mit einer Richtung und einem Betrag, der der Abweichung Δ entspricht, werden über eine Aktivierung des der Drahtgruppe zugeordneten Antriebselements herbeigeführt. Nur wenn keine Fehllage der Schnittspalte vorliegt (Δ = 0), was im gezeigten Beispiel zunächst ungefähr bei einer Eindringtiefe von -100 mm der Fall ist, unterbleibt das Herbeiführen solcher Ausgleichsbewegungen.

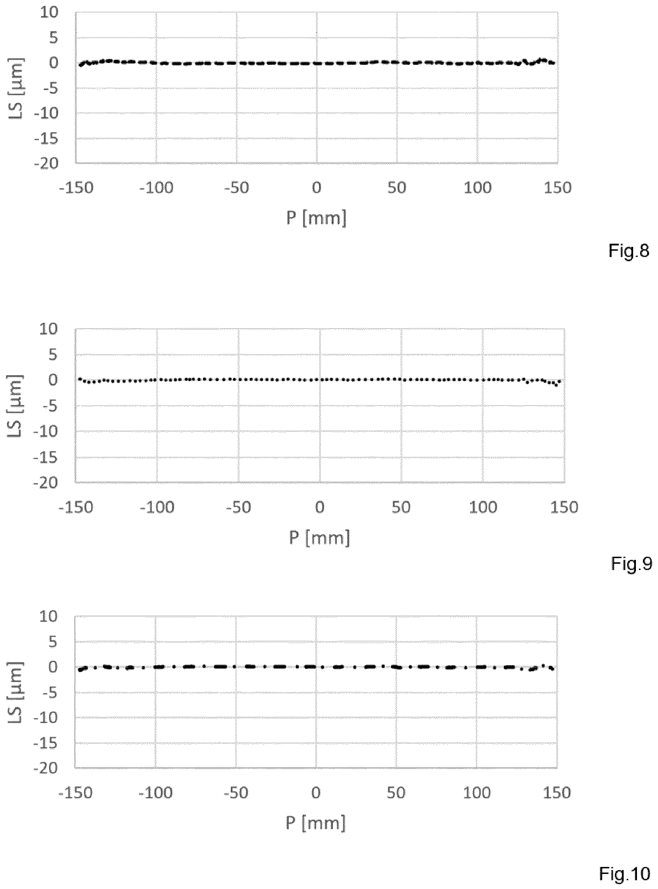

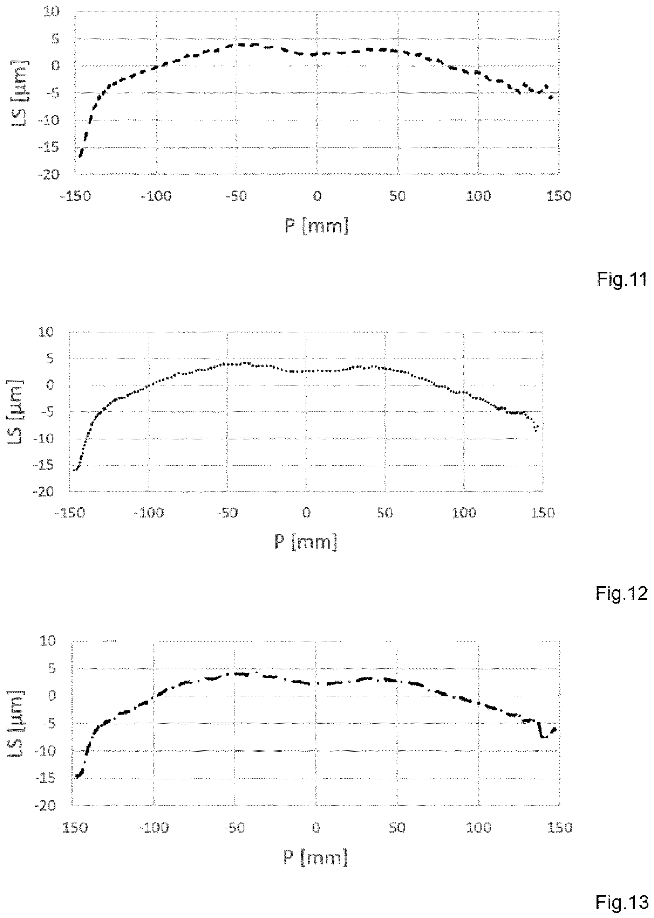

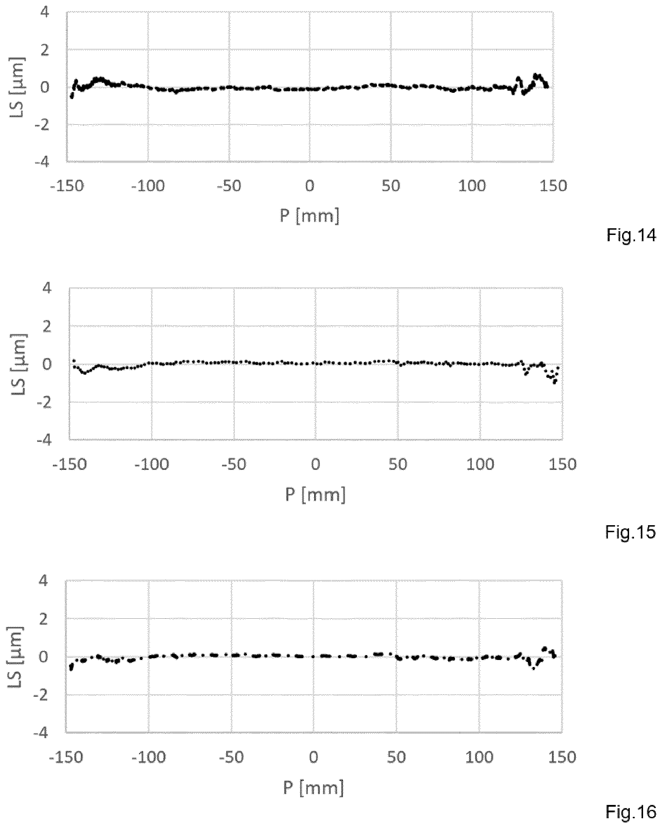

Fig.8 bis Fig.13 zeigen Höhenlinien LS von jeweils drei Halbleiterscheiben, die durch Drähte einer Drahtgruppe von einem Werkstück abgetrennt wurden, wobei während des Abtrennens der Halbleiterscheiben vom Korrekturprofil vorgegebene Ausgleichsbewegungen der Drähte der Drahtgruppe herbeigeführt wurden (Fig.8 bis Fig.10) oder auf das Herbeiführen solcher Ausgleichsbewegungen verzichtet wurde (Fig.11 bis Fig.13). Die Höhenlinien sind jeweils von der Medianfläche einer warp-Messung abgeleitet, wobei Messwerte der Medianfläche selektiert wurden, die auf einer Linie liegen, die dem Durchmesser der jeweiligen Halbleiterscheibe in Richtung des Werkstücks beim Abtrennen der Halbleiterscheibe folgt. Die Position der Halbleiterscheiben im Werkstück war so, dass beim Abtrennen der Halbleiterscheiben zwischen jeder der drei Halbleiterscheiben 50 weitere Halbleiterscheiben entstanden. Wie der Vergleich der Höhenlinien offenlegt, werden Halbleiterscheiben durch Anwendung des offenbarten Verfahrens deutlich ebener und zwar ohne besonderen Einfluss von deren Position im Werkstück. Das bestätigen auch Fig.14 bis Fig.16, die sich von Fig.8 bis Fig.10 nur dadurch unterscheiden, dass bei ihnen die Skalierung der Ordinate höher aufgelöst ist.

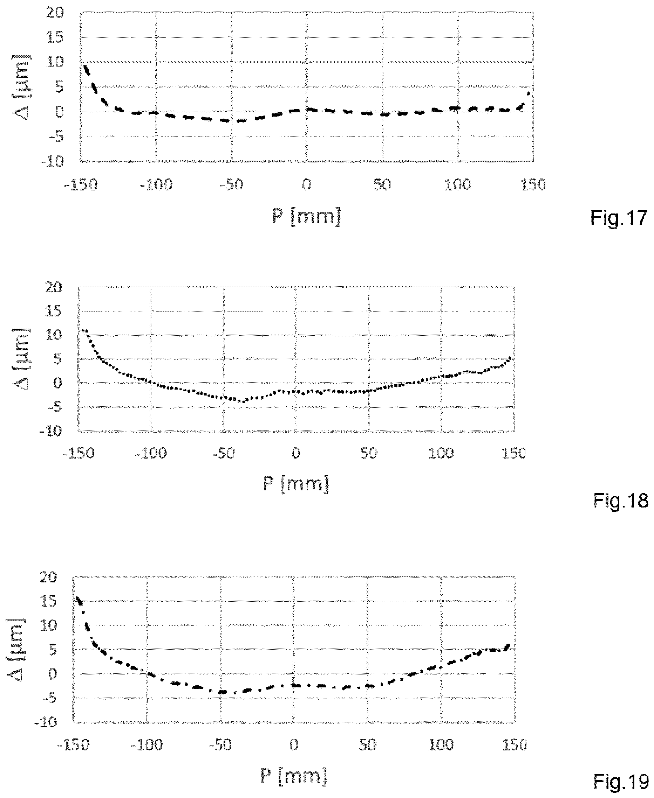

Die Fig.17, 18 und 19 zeigen, wie sich ein drahtsägespezifisches Korrekturprofil im Verlauf der Bearbeitung von mehreren Werkstücken stetig verändern kann. Es ist deshalb vorteilhaft, eine Schwelle für die Abweichung Δ zu definieren, bei deren Überschreiten vorsorgliche Wartungsmaßnahmen eingeleitet werden. Die Schwelle kann beispielsweise so definiert sein, dass erst ein drahtsägespezifisches Korrekturprofil mit einer maximale Abweichung Δₘₐₓ, wie sie in Fig.19 dargestellt ist, zur Folge hat, dass vorsorgliche Wartungsmaßnahmen eingeleitet werden.

Die bezüglich der vorstehend aufgeführten Ausführungsformen des Verfahrens angegebenen Merkmale können entsprechend auf die Vorrichtung übertragen werden. Umgekehrt können die bezüglich der vorstehend ausgeführten Ausführungsformen der Vorrichtung angegebenen Merkmale entsprechend auf das Verfahren übertragen werden. Diese und andere Merkmale der Ausführungsformen werden in der Figurenbeschreibung erläutert. Die einzelnen Merkmale können entweder separat oder in Kombination als Ausführungsformen verwirklicht werden. Die vorstehende Beschreibung beispielhafter Ausführungsformen ist exemplarisch zu verstehen. Die damit erfolgte Offenbarung ermöglicht es dem Fachmann einerseits, die Ausführungsbeispiele und die damit verbundenen Vorteile zu verstehen, und umfasst andererseits im Verständnis des Fachmanns auch offensichtliche Abänderungen und Modifikationen der beschriebenen Strukturen und Verfahren.

Daher sollen alle derartigen Abänderungen und Modifikationen sowie Äquivalente durch den Schutzbereich des Anspruchs abgedeckt sein.

## Patentansprüche

1. Halbleiterscheibe aus einkristallinem Silizium mit einer oberen Seitenfläche und einer unteren Seitenfläche und einem Durchmesser von mindestens 200 mm, **gekennzeichnet durch**
einen warp von weniger als 1,2 µm, wobei der warp entsprechend der Norm SEMI MF 1390-0218 bestimmt wird;
eine Nanotopographie der oberen Seitenfläche, ausgedrückt als THA25 10 % von weniger als 5 nm; und
eine teilflächenbezogene Nanotopographie der oberen Seitenfläche von weniger als 6 nm, ausgedrückt als maximaler peak-to-valley Abstand auf einer Teilfläche und bezogen auf Teilflächen mit einem Flächeninhalt von jeweils 25 mm x 25 mm; wobei
zur Untersuchung der Nanotopographie mittels eines Interferometers eine Höhenkarte der oberen Seitenfläche der Halbleiterscheibe gebildet wird, die gefiltert wird und über die ein Analysenfenster mit definierter Analysenfläche bewegt wird;
das Analysenfenster einen kreisförmigen Umfang und einen Durchmesser von 25 mm hat und das ungefilterte Topographiesignal mit einem einfachen Gaußschen Hoch-Pass-Filter mit 20 mm Grenzwellenlänge gefiltert wird;
die Auswertung der Höhenunterschiede im Analysenfenster entsprechend der in den Normen SEMI M43-0418 und SEMI M78-0618 festgelegten Verfahrensvorschriften erfolgt;
ein THA25 10% von weniger als 5 nm bedeutet, dass höchstens 10 % der analysierten Fläche der oberen Seitenfläche der Halbleiterscheibe im Analysenfenster mit kreisförmigem Umfang und einem Durchmesser von 25 mm einen maximalen Höhenunterschied von 5 nm oder größer hat; und
zur Bestimmung der teilflächenbezogenen Nanotopographie die obere Seitenfläche der Halbleiterscheibe in Teilflächen mit einem Flächeninhalt von 25 mm x 25 mm unterteilt wird, die sich um eine Teilfläche gruppieren, deren linke untere Ecke im Zentrum der oberen Seitenfläche der Halbleiterscheibe angeordnet ist.

## Claims

1. Semiconductor wafer composed of monocrystalline silicon having an upper side surface and a lower side surface and a diameter of at least 200 mm, **characterized by**
a warp of less than 1.2 µm, the warp being determined in accordance with the SEMI MF 1390-0218 standard;
a nanotopography of the upper side surface, expressed as THA25 10%, of less than 5 nm; and
a site-referenced nanotopography of the upper side surface of less than 6 nm, expressed as a maximum peak-to-valley distance on a site and referenced to sites with a surface area of in each case 25 mm x 25 mm; wherein
in order to examine the nanotopography by means of an interferometer, a height map of the upper side surface of the semiconductor wafer is formed, which is filtered and over which an analysis window with a defined analysis area is moved;
the analysis window has a circular circumference and a diameter of 25 mm and the unfiltered topography signal is filtered with a single Gaussian high-pass filter with a cut-off wavelength of 20 mm;
the evaluation of the height differences in the analysis window is carried out in accordance with the method protocols defined in the SEMI M43-0418 and SEMI M78-0618 standards;
a THA25 10% of less than 5 nm means that at most 10% of the analysed area of the upper side surface of the semiconductor wafer in the analysis window with a circular circumference and a diameter of 25 mm has a maximum height difference of 5 nm or greater; and
in order to determine the site-referenced nanotopography, the upper side surface of the semiconductor wafer is subdivided into sites with a surface area of 25 mm x 25 mm, which are grouped around a site whose lower left corner is arranged in the centre of the upper side surface of the semiconductor wafer.

## Revendications

1. Plaquette semi-conductrice en silicium monocristallin avec une surface latérale supérieure et une surface latérale inférieure et un diamètre d'au moins 200 mm, **caractérisée par**
un warp inférieur à 1,2 µm, le warp étant déterminé conformément à la norme SEMI MF 1390-0218 ;
une nanotopographie de la surface latérale supérieure, exprimée en THA25 10 %, inférieure à 5 nm ; et
une nanotopographie de surface de la surface latérale supérieure inférieure à 6 nm, exprimée en termes de distance maximale de pic à vallée sur une surface partielle et rapportée à des surfaces partielles ayant chacune une superficie de 25 mm x 25 mm ;
pour l'examen de la nanotopographie au moyen d'un interféromètre, une carte de hauteur de la surface latérale supérieure de la plaquette semi-conductrice étant formée, qui est filtrée et sur laquelle est déplacée une fenêtre d'analyse avec une surface d'analyse définie ;
la fenêtre d'analyse ayant une circonférence circulaire et un diamètre de 25 mm et le signal topographique non filtré étant filtré avec un simple filtre passe-haut gaussien d'une longueur d'onde de coupure de 20 mm ;
l'évaluation des différences de hauteur dans la fenêtre d'analyse étant effectuée conformément aux procédures définies dans les normes SEMI M43-0418 et SEMI M78-0618 ; un THA25 10 % inférieur à 5 nm signifiant qu'au plus 10 % de la surface analysée de la surface latérale supérieure de la plaquette semi-conductrice dans la fenêtre d'analyse à périmètre circulaire de 25 mm de diamètre a une différence de hauteur maximale de 5 nm ou plus ; et pour déterminer la nanotopographie par surface partielle, la surface latérale supérieure de la plaquette semi-conductrice étant divisée en surfaces partielles d'une superficie de 25 mm x 25 mm, qui se regroupent autour d'une surface partielle dont le coin inférieur gauche est agencé au centre de la surface latérale supérieure de la plaquette semi-conductrice.
